# EUROPEAN PATENT APPLICATION

(11) **EP 4 832 711 A1**
(43) Date of publication of application: **28.10.2026**
(21) Application number: 24906426.2
(22) Date of filing: 19.12.2024
(51) Int. Cl.: H10K 39/15, H10K 71/12, H10K 71/16, H10K 71/10, H10K 71/40, H10K 71/60, H10K 30/85, H10K 30/86

(54) **PEROVSKITE-SILICON TANDEM SOLAR CELL AND PREPARATION METHOD THEREFOR**

(30) Priority: 19.12.2023 CN 202311751147
(71) Applicant: CHINT New Energy Technology Co., Ltd., Haining, Zhejiang 314400 (CN)
(72) Inventor: HUANG, Haiyan, Jiaxing, Zhejiang 314400 (CN); HSU, Wei-Chih, Jiaxing, Zhejiang 314400 (CN); HE, Sheng, Jiaxing, Zhejiang 314400 (CN); WANG, Shumao, Jiaxing, Zhejiang 314400 (CN); LI, Zijia, Jiaxing, Zhejiang 314400 (CN)
(74) Representative: PGA S.p.A., Milano, Succursale di Lugano
(86) International application number: PCT/CN2024/140462
(87) International publication number: WO 2025/130947

(57) **Abstract**

Provided are a perovskite-silicon tandem solar cell and a preparation method therefor. The perovskite-silicon tandem solar cell comprises a silicon-based battery, an ITO intermediate composite layer, a first hole transport layer, a second hole transport layer, a perovskite light absorption layer, a first electron transport layer, a second electron transport layer, a top transparent conductive layer, and a conductive metal electrode, which are all sequentially stacked. The perovskite-silicon tandem solar cell of the present application can fully achieve the advantages of perovskite batteries and crystalline silicon batteries, reduce the effect of humidity and oxygen on the perovskite material while reducing the optical coupling effect of the perovskite material and the crystalline silicon material, lower the interface effect, and improve the efficiency and stability of the perovskite-silicon tandem solar cell.

## Description

### FIELD

The present disclosure relates to the field of photovoltaic technology, in particular to a perovskite-silicon tandem solar cell and a method for manufacturing the same.

### BACKGROUND

Perovskite-silicon tandem solar cells are of a novel solar cell structure that integrates a perovskite solar cell with a crystalline silicon solar cell in a tandem configuration. The design of this tandem structure is intended to improve solar energy conversion efficiency and achieve broader light absorption across a spectral range. The working principle of the perovskite-silicon tandem solar cell is that, in the tandem structure, the perovskite solar cell is on the top layer to absorb high-energy light, while the crystalline silicon solar cell is on the bottom layer to absorb low-energy light.

The perovskite-silicon tandem solar cells offer several advantages. First, since the perovskite solar cell absorbs high-energy light and the crystalline silicon solar cell absorbs low-energy light, solar energy can be utilized more effectively across the spectral range. Second, perovskite materials exhibit a high light absorption coefficient and high photoelectric conversion efficiency, while crystalline silicon materials possess a long lifetime and good stability. By integrating these two materials, their advantages can be fully utilized to achieve higher overall performance.

However, the perovskite materials are sensitive to humidity and oxygen, prone to decomposition and degradation, which leads to the deterioration of cell performance.

CN112582545A discloses a tandem perovskite solar cell and a production method therefor, which belongs to the field of solar cell device technology. The solar cell comprises a high-transmittance glass layer, a transparent electrode layer, a hole transport layer, a first perovskite active layer, a first electron transport layer, a multi-functional tin oxide layer, a second perovskite active layer, a second electron transport layer and a metal counter electrode layer, which are sequentially connected to form an integral solar cell. The multi-functional tin oxide layer has a thickness of 10 nm to 50 nm, and tin oxide nanoparticles in the multi-functional tin oxide layer have a diameter of 5 nm to 20 nm.

CN116033767A discloses a crystalline silicon-perovskite tandem solar cell and a production method therefor. The solar cell comprises: a crystalline silicon solar cell, an intermediate transparent conductive layer, a metal oxide layer, and a perovskite solar cell, which are sequentially stacked from bottom to top. The intermediate transparent conductive layer covers a portion of the crystalline silicon solar cell, each edge of the intermediate transparent conductive layer is recessed by a predetermined distance relative to the edge of the crystalline silicon solar cell adjacent to the intermediate transparent conductive layer, the metal oxide layer covers the intermediate transparent conductive layer and regions of the crystalline silicon solar cell not covered by the intermediate transparent conductive layer.

The perovskite-silicon tandem solar cell prepared by the above-mentioned scheme has a relatively high preparation cost. In addition, there are interface issues between the two materials, as well as severe optical coupling effects, which affect the photoelectric conversion efficiency.

### SUMMARY

The following is an overview of the subject matter described in detail herein. The overview is not intended to limit the scope of claims.

A perovskite-silicon tandem solar cell and a method for manufacturing the same are provided according to the present disclosure. In the present disclosure, the perovskite-silicon tandem solar cell can fully harness the advantages of both the perovskite solar cell and the crystalline silicon solar cell. While mitigating the impact of humidity and oxygen on perovskite materials, the perovskite-silicon tandem solar cell reduces the light coupling effect between perovskite materials and crystalline silicon materials, minimizes interface effects, and improves the efficiency and stability of the perovskite-silicon tandem solar cell.

In a first aspect, a perovskite-silicon tandem solar cell is provided according to the present disclosure. The perovskite-silicon tandem solar cell comprises a crystalline silicon solar cell substrate, an indium tin oxide (ITO) intermediate composite layer, a first hole transport layer, a second hole transport layer, a perovskite light-absorbing layer, a first electron transport layer, a second electron transport layer, a top transparent conductive layer and a conductive metal electrode, which are sequentially stacked.

In the present disclosure, a crystalline silicon solar cell and a perovskite solar cell are integrated to form a tandem solar cell, which can more effectively utilize solar energy within the spectral range. The perovskite materials exhibit a high light absorption coefficient and high photoelectric conversion efficiency, while crystalline silicon materials possess a long lifetime and good stability. By integrating these two materials, their advantages can be fully utilized to achieve higher overall performance. Two hole transport layers of different materials are provided in the perovskite solar cell. The synergistic effect between the first hole transport layer and the second hole transport layer can generate multiple gain effects, which reduce charge loss and improve cell performance, thereby increasing photoelectric conversion efficiency. Two electron transport layers of different materials are provided in the perovskite solar cell. Fullerene C60 serves as an electron transport material, and tin oxide serves as both an electron transport material and a protective layer against physical vapor deposition (PVD) sputtering damage.

Preferably, the crystalline silicon solar cell substrate comprises a back conductive metal electrode, a bottom transparent conductive layer, a p-type amorphous silicon layer, a first intrinsic amorphous silicon layer, a silicon wafer, a second intrinsic amorphous silicon layer and an n-type amorphous silicon layer, which are sequentially stacked.

Preferably, the n-type amorphous silicon layer is connected to the ITO intermediate composite layer.

Preferably, the first transport layer includes a nickel oxide hole transport layer.

Preferably, the second hole transport layer includes a phosphoric acid carbazole (PACz)-based hole transport layer.

Preferably, a material of the second hole transport layer includes any one or a combination of at least two selected from the group consisting of [2-(9-carbazol-9-yl)ethyl]phosphonic acid (2PACz), [2-(dimethoxy-9-9-yl)ethyl]phosphonic acid (MeO-2PACz), [2-(3,6-diphenyl-9H-carbazol-9-yl)ethyl]phosphonic acid (Me-2PACz), [4-(3,6-dimethoxy-9H-carbazol-9-yl)butyl]phosphonic acid (MeO-4PACz), [4-(3,6-dimethyl-9H-carbazol-9-yl)butyl]phosphonic acid (Me-4PACz), and [4-(9H-carbazol-9-yl)butyl]phosphonic acid (4PACz).

Preferably, the second hole transport layer comprises formamidinium iodide.

In the present disclosure, the performance of the solar cell can be significantly improved by incorporating the formamidinium iodide into the hole transport layer to form an interpenetrating interface heterojunction structure between the hole transport layer and the perovskite. The photoelectric conversion efficiency of the perovskite-silicon tandem solar cell can be enhanced by reducing the hole transport distance, increasing carrier transport efficiency, increasing open-circuit voltage and short-circuit current, and improving the fill factor.

Preferably, the first electron transport layer includes a fullerene C60 thin-film electron transport layer.

Preferably, the second electron transport layer includes a SnO₂ thin-film electron transport layer.

Preferably, the top transparent conductive layer includes an ITO thin film.

Preferably, the conductive metal electrode includes a silver metal electrode.

Preferably, the ITO intermediate composite layer has a thickness of 15 nm to 25 nm, for example, 15 nm, 18 nm, 20 nm, 22 nm, or 25 nm.

Preferably, the first hole transport layer has a thickness of 10 nm to 20 nm, for example, 10 nm, 12 nm, 15 nm, 18 nm, or 20 nm.

Preferably, the second hole transport layer has a thickness of 2 nm to 5 nm.

Preferably, the perovskite light-absorbing layer has a thickness of 350 nm to 600 nm, for example, 350 nm, 400 nm, 450 nm, 500 nm, or 600 nm.

Preferably, the first electron transport layer has a thickness of 15 nm to 25 nm, for example, 15 nm, 18 nm, 20 nm, 22 nm, or 25 nm.

Preferably, the second electron transport layer has a thickness of 10 nm to 20 nm, for example, 10 nm, 12 nm, 15 nm, 18 nm, or 20 nm.

Preferably, the top transparent conductive layer has a thickness of 100 nm to 150 nm, for example, 100 nm, 110 nm, 120 nm, 140 nm, or 150 nm.

Preferably, the conductive metal electrode has a thickness of 800 nm to 1000 nm, for example, 800 nm, 850 nm, 900 nm, 950 nm, or 1000 nm.

In a second aspect, a method for manufacturing the perovskite-silicon tandem solar cell as described in the first aspect is provided according to the present disclosure. The method comprises the following steps:
(1) depositing an ITO intermediate composite layer on an n-type microcrystalline silicon of a crystalline silicon solar cell substrate, then sputtering a first hole transport layer on the ITO composite layer, and spin-coating a second hole transport layer on the first hole transport layer;
(2) evaporating a divalent metal halide on the second hole transport layer, spin-coating an organic halide solution on the layer obtained from the evaporating, and annealing to obtain a perovskite light-absorbing layer;
(3) evaporating a first electron transport layer on the perovskite light-absorbing layer, and depositing a second electron transport layer on the first electron transport layer by atomic layer deposition;
(4) sputtering a top transparent conductive layer on the second electron transport layer, and evaporating a conductive metal electrode on the top transparent conductive layer to obtain the perovskite-silicon tandem solar cell.

Preferably, in step (1), a concentration of PACz-based compound in a spin-coating solution for spin-coating the second hole transport layer is 0.5 mmol/L to 1.5 mmol/L, for example, 0.5 mmol/L, 0.8 mmol/L, 1 mmol/L, 1.2 mmol/L or 1.5 mmol/L

Preferably, the spin-coating is performed at a speed of 2000 rad/s to 4000 rad/s, for example, 2000 rad/s, 2500 rad/s, 3000 rad/s, 3500 rad/s, or 4000 rad/s.

Preferably, the spin-coating solution comprises formamidinium iodide.

Preferably, a concentration of the formamidinium iodide in the spin-coating solution is 5 mg/mL to 15 mg/mL, for example, 5 mg/mL, 8 mg/mL, 10 mg/mL, 12 mg/mL, or 15 mg/mL.

Preferably, an annealing treatment is performed after spin-coating the second hole transport layer.

Preferably, the annealing treatment is performed at a temperature of 80°C to 120°C, for example, 80°C, 90°C, 100°C, 110°C, or 120°C.

Preferably, a duration of the annealing treatment is 8 min to 12 min, for example, 8 min, 9 min, 10 min, 11 min, or 12 min.

Preferably, in step (2), the divalent metal halide includes any one or a combination of at least two selected from the group consisting of lead iodide, cesium iodide and lead bromide.

Preferably, a rate of evaporating the lead iodide is 1 Å/s to 25 Å/s, for example, 1 Å/s, 5 Å/s, 10 Å/s, 20 Å/s, or 25 Å/s.

Preferably, a rate of evaporating the cesium iodide is 0.04 Å/s to 1 Å/s, for example, 0.04 Å/s, 0.08 Å/s, 0.1 Å/s, 0.5 Å/s, or 1 Å/s.

Preferably, a rate of evaporating the lead bromide is 0.1 Å/s to 2.5 Å/s, for example, 0.1 Å/s, 1 Å/s, 1.5 Å/s, 2 Å/s, or 2.5 Å/s.

Preferably, in step (2), a solute of the organic halide solution includes any one or a combination of at least two selected from the group consisting of formamidinium iodide, formamidinium bromide, methylammonium iodide, and methylammonium chloride.

Preferably, a solvent of the organic halide solution includes isopropanol.

Preferably, a concentration of the organic halide solution is 1 mol/L to 1.5 mol/L, for example, 1 mol/L, 1.2 mol/L, 1.3 mol/L, 1.4 mol/L, or 1.5 mol/L.

Preferably, the annealing is performed at a temperature of 100°C to 150°C, for example, 100°C, 110°C, 120°C, 130°C, or 150°C.

Preferably, a duration of the annealing is 10 min to 15 min, for example, 10 min, 11 min, 12 min, 13 min, or 15 min.

Compared with related technologies, the present disclosure has the following beneficial effects:
(1) The perovskite-silicon tandem solar cell in the present disclosure can fully harness the advantages of both the perovskite solar cell and the crystalline silicon solar cell. While mitigating the impact of humidity and oxygen on perovskite materials, the perovskite-silicon tandem solar cell reduces the light coupling effect between perovskite materials and crystalline silicon materials, minimizes interface effects, and improves the efficiency and stability of the perovskite-silicon tandem solar cell.
(2) After incorporating the formamidinium iodide into the hole transport layer, the open-circuit voltage, short-circuit current, and the fill factor of the tandem solar cell are all improved, and the conversion efficiency is further improved. This is because the formamidinium iodide is incorporated into the hole transport layer to form an interpenetrating interface heterojunction structure between the hole transport layer and the perovskite, which reduces the hole transport distance and improves the transport performance of hole carriers.

Other aspects can be understood after reading and understanding the accompanying drawings and detailed description.

### BRIEF DESCRIPTION OF THE DRAWINGS

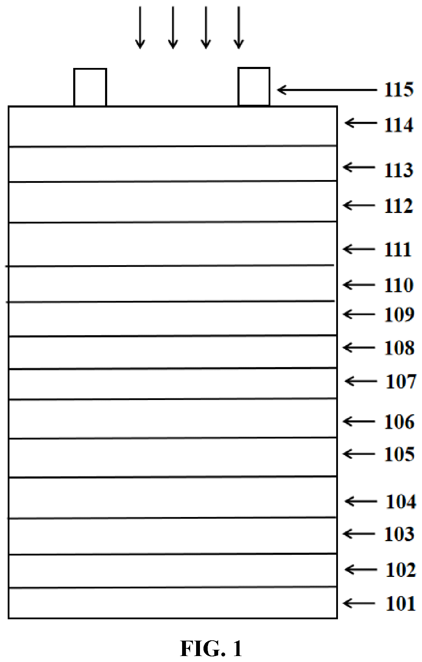

FIG. 1 is a structural schematic diagram of a perovskite-silicon tandem solar cell according to an example of the present disclosure.

### Reference numerals:

| | | | |
|---|---|---|---|
| 101: | back conductive metal electrode; | 102: | back transparent conductive layer; |
| 103: | p-type amorphous silicon layer; | 104: | first intrinsic amorphous silicon layer; |
| 105: | silicon wafer; | 106: | second intrinsic amorphous silicon layer; |
| 107: | n-type amorphous silicon layer; | 108: | ITO intermediate composite layer; |
| 109: | nickel oxide hole transport layer (first hole transport layer); | | |
| 110: | PACz-based hole transport layer (second hole transport layer); | | |
| 111: | perovskite absorption layer; | | |
| 112: | fullerene C60 thin-film electron transport layer (first electron transport layer); | | |
| 113: | SnO₂ thin-film electron transport layer (second electron transport layer); | | |
| 114: | top transparent conductive layer; | 115: | conductive metal electrode. |

### DETAILED DESCRIPTION

Hereinafter technical solutions of the present disclosure are further described through specific embodiments. Those skilled in the art should understand that the embodiments described are merely illustrative of the present disclosure and should not be considered as specific limitations thereof.

The crystalline silicon solar cell in examples and comparative examples of the present disclosure comprises, a back conductive metal electrode, a bottom transparent conductive layer, a p-type amorphous silicon layer, a first intrinsic amorphous silicon layer, a silicon wafer, a second intrinsic amorphous silicon layer, and an n-type amorphous silicon layer, which are sequentially stacked.

### Example 1

The example provides a perovskite-silicon tandem solar cell, which was manufactured by the following method:
(1) An ITO composite layer with a thickness of 20 nm was deposited on an n-type microcrystalline silicon of a crystalline silicon solar cell substrate. A nickel oxide hole transport layer (first hole transport layer) with a thickness of 15 nm was sputtered onto the ITO composite layer via magnetron sputtering. A PACz-based hole transport layer was spin-coated onto the nickel oxide hole transport layer, using a spin-coating solution with a concentration of [2-(dimethoxy-9-9-yl)ethyl]phosphonic acid (MeO-2PACz) being 1 mmol/L and a concentration of formamidinium iodide being 10 g/L. The PACz-based hole transport layer (second hole transport layer) with a thickness of 2 nm to 5 nm was obtained.
(2) Lead iodide, cesium iodide, and lead bromide were evaporated onto the second hole transport layer by co-evaporation. The lead iodide was evaporated at a rate of 15 Å/s, the cesium iodide was evaporated at a rate of 0.2 Å/s, and the lead bromide was evaporated at a rate of 1 Å/s. A mixed organic solution of formamidinium iodide and isopropanol, with a concentration of 1.2 mol/L, was spin-coated onto the evaporated layer and annealed at 120 °C for 12 min to obtain a perovskite light-absorbing layer with a thickness of 530 nm.
(3) A fullerene C60 electron transport layer (first electron transport layer) with a thickness of 20 nm was prepared on the perovskite light-absorbing layer. A tin oxide thin film (second electron transport layer) with a thickness of 15 nm was deposited on the fullerene C60 electron transport layer by atomic layer deposition.
(4) An ITO thin film (top transparent conductive layer) with a thickness of 120 nm was sputtered on a surface of the tin oxide thin film. A silver metal electrode (conductive metal electrode) with a thickness of 900 nm was evaporated on a surface of the ITO thin film to obtain the perovskite-silicon tandem solar. Reference is made to FIG. 1, which is a structural schematic diagram of the perovskite-silicon tandem solar cell. In the figure, 101 is the back conductive metal electrode, 102 is the back transparent conductive layer, 103 is the p-type amorphous silicon layer, 104 is the first intrinsic amorphous silicon layer, 105 is the silicon wafer, 106 is the second intrinsic amorphous silicon layer, 107 is the n-type amorphous silicon layer, 108 is the ITO intermediate composite layer, 109 is the nickel oxide hole transport layer (first hole transport layer), 110 is the PACz-based hole transport layer (second hole transport layer), 111 is the perovskite absorption layer, 112 is the fullerene C60 thin-film electron transport layer (first electron transport layer), 113 is the SnO₂ thin-film electron transport layer (second electron transport layer), 114 is the top transparent conductive layer; and 115 is the conductive metal electrode.

### Example 2

The example provides a perovskite-silicon tandem solar cell, which was manufactured by the following method:
(1) An ITO composite layer with a thickness of 15 nm was deposited on an n-type microcrystalline silicon of a crystalline silicon solar cell substrate. A nickel oxide hole transport layer (first hole transport layer) with a thickness of 10 nm was sputtered onto the ITO composite layer via magnetron sputtering. A PACz-based hole transport layer was spin-coated onto the nickel oxide hole transport layer, using a spin-coating solution with a concentration of [4-(3,6-dimethoxy-9H-carbazol-9-yl)butyl]phosphonic acid (MeO-4PACz) being 0.5 mmol/L and a concentration of formamidinium iodide being 5 g/L. The PACz-based hole transport layer (second hole transport layer) with a thickness of 2 nm to 5 nm was obtained.
(2) Lead iodide, cesium iodide, and lead bromide were evaporated onto the second hole transport layer by co-evaporation. The lead iodide was evaporated at a rate of 1 Å/s, the cesium iodide was evaporated at a rate of 0.04 Å/s, and the lead bromide was evaporated at a rate of 0.1 Å/s. A mixed organic solution of formamidinium iodide and isopropanol, with a concentration of 1 mol/L, was spin-coated onto the evaporated layer and annealed at 100 °C for 15 min to obtain a perovskite light-absorbing layer with a thickness of 350 nm.
(3) A fullerene C60 electron transport layer (first electron transport layer) with a thickness of 15 nm was prepared on the perovskite light-absorbing layer. A tin oxide thin film (second electron transport layer) with a thickness of 10 nm was deposited on the fullerene C60 electron transport layer by atomic layer deposition.
(4) An ITO thin film (top transparent conductive layer) with a thickness of 100 nm was sputtered on a surface of the tin oxide thin film. A silver metal electrode (conductive metal electrode) with a thickness of 800 nm was evaporated on a surface of the ITO thin film to obtain the perovskite-silicon tandem solar. Reference is made to FIG, 1, which is a structural schematic diagram of the perovskite-silicon tandem solar cell. In the figure, 101 is the back conductive metal electrode, 102 is the back transparent conductive layer, 103 is the p-type amorphous silicon layer, 104 is the first intrinsic amorphous silicon layer, 105 is the silicon wafer, 106 is the second intrinsic amorphous silicon layer, 107 is the n-type amorphous silicon layer, 108 is the ITO intermediate composite layer, 109 is the nickel oxide hole transport layer (first hole transport layer), 110 is the PACz-based hole transport layer (second hole transport layer), 111 is the perovskite absorption layer, 112 is the fullerene C60 thin-film electron transport layer (first electron transport layer), 113 is the SnO₂ thin-film electron transport layer (second electron transport layer), 114 is the top transparent conductive layer; and 115 is the conductive metal electrode.

### Example 3

The example provides a perovskite-silicon tandem solar cell, which was manufactured by the following method:
(1) An ITO composite layer with a thickness of 25 nm was deposited on an n-type microcrystalline silicon of a crystalline silicon solar cell substrate. A nickel oxide hole transport layer (first hole transport layer) with a thickness of 20 nm was sputtered onto the ITO composite layer via magnetron sputtering. A PACz-based hole transport layer was spin-coated onto the nickel oxide hole transport layer, using a spin-coating solution with a concentration of [4-(9H-carbazol-9-yl)butyl]phosphonic acid (4PACz) being 1.5 mmol/L and a concentration of formamidinium iodide being 15 g/L. The PACz-based hole transport layer (second hole transport layer) with a thickness of 2 nm to 5 nm was obtained.
(2) Lead iodide, cesium iodide, and lead bromide were evaporated onto the second hole transport layer by co-evaporation. The lead iodide was evaporated at a rated of 25 Å/s, the cesium iodide was evaporated at a rate of 1 Å/s, and the lead bromide was evaporated at a rate of 2.5 Å/s. A mixed organic solution of formamidinium iodide and isopropanol, with a concentration of 1.5 mol/L, was spin-coated onto the evaporated layer and annealed at 150 °C for 10 min to obtain a perovskite light-absorbing layer with a thickness of 600 nm.
(3) A fullerene C60 electron transport layer (first electron transport layer) with a thickness of 25 nm was prepared on the perovskite light-absorbing layer. A tin oxide thin film (second electron transport layer) with a thickness of 20 nm was deposited on the fullerene C60 electron transport layer by atomic layer deposition.
(4) An ITO thin film (top transparent conductive layer) with a thickness of 150 nm was sputtered on a surface of the tin oxide thin film. A silver metal electrode (conductive metal electrode) with a thickness of 1000 nm was evaporated on a surface of the ITO thin film to obtain the perovskite-silicon tandem solar. Reference is made to FIG, 1, which is a structural schematic diagram of the perovskite-silicon tandem solar cell. In the figure, 101 is the back conductive metal electrode, 102 is the back transparent conductive layer, 103 is the p-type amorphous silicon layer, 104 is the first intrinsic amorphous silicon layer, 105 is the silicon wafer, 106 is the second intrinsic amorphous silicon layer, 107 is the n-type amorphous silicon layer, 108 is the ITO intermediate composite layer, 109 is the nickel oxide hole transport layer (first hole transport layer), 110 is the PACz-based hole transport layer (second hole transport layer), 111 is the perovskite absorption layer, 112 is the fullerene C60 thin-film electron transport layer (first electron transport layer), 113 is the SnO₂ thin-film electron transport layer (second electron transport layer), 114 is the top transparent conductive layer; and 115 is the conductive metal electrode.

### Example 4

The example differs from Example 1 only in that a concentration of formamidinium iodide in the spin-coating solution was 1 mg, and all other conditions and parameters were identical to Example 1.

### Example 5

The example differs from Example 1 only in that a concentration of formamidinium iodide in the spin-coating solution was 20 mg, and all other conditions and parameters were identical to Example 1.

### Example 6

The example differs from Example 1 only in that no formamidinium iodide was added in the spin-coating solution, and all other conditions and parameters were identical to Example 1.

### Example 7

The example differs from Example 1 only in that a concentration of the organic halide solution was 0.5 mol/L, and all other conditions and parameters were identical to Example 1.

### Example 8

The example differs from Example 1 only in that a concentration of the organic halide solution was 2 mol/L, and all other conditions and parameters were identical to Example 1.

### Comparative Example 1

The comparative example differs from Example 1 only in that no nickel oxide hole transport layer was provided, and only a single layer of PACz-based hole transport layer was provided, while all other conditions and parameters were identical to Example 1.

### Comparative Example 2

The comparative example differs from Example 1 only in that no PACz-based hole transport layer was provided, and only a single layer of nickel oxide hole transport layer was provided, while all other conditions and parameters were identical to Example 1.

### Performance Test:

The photoelectric conversion efficiency of the perovskite-silicon tandem solar cells prepared in both examples and the comparative example was tested under standard test conditions (1.5 AM). The test results are shown in Table 1:

**Table 1**

| | V_{oc}(V) | J_{sc}(mA·cm⁻²) | FF(%) | PCE(%) |
|---|---|---|---|---|
| Example 1 | 1.86 | 19.88 | 81.11 | 29.99 |
| Example 2 | 1.85 | 19.74 | 80.47 | 29.39 |
| Example 3 | 1.85 | 19.68 | 81.57 | 29.70 |
| Example 4 | 1.84 | 19.48 | 81.57 | 29.24 |
| Example 5 | 1.85 | 19.47 | 80.87 | 29.13 |
| Example 6 | 1.82 | 19.25 | 80.14 | 28.08 |
| Example 7 | 1.85 | 19.38 | 81.47 | 29.21 |
| Example 8 | 1.85 | 19.46 | 81.12 | 29.20 |
| Comparative Example 1 | 1.85 | 19.52 | 80.88 | 29.21 |
| Comparative Example 2 | 1.85 | 19.43 | 80.98 | 29.11 |

As shown in Table 1, Examples 1-3 demonstrate that the formamidinium iodide can play the same role in different PACz-based hole transport layers.

From a comparison of Examples 1 and 4-5, it can be concluded that in the preparation process of the perovskite-silicon tandem solar cell of the preset disclosure, the concentration of the formamidinium iodide in the spin-coating solution affects the performance of the perovskite-silicon tandem solar cell. By controlling the concentration of the formamidinium iodide in the spin-coating solution at 5 mg/mL to 15 mg/mL, the perovskite-silicon tandem solar cell exhibits improved performance. In the case that the concentration of the formamidinium iodide in the spin-coating solution is too high, excessive formamidinium iodide hinders charge transport. In the case that the concentration of the formamidinium iodide in the spin-coating solution is too low, an interpenetrating interface heterojunction structure cannot be formed between the hole transport layer and the perovskite.

From a comparison of Examples 1 and 6, it can be concluded that in the preparation process of the perovskite-silicon tandem solar cell of the preset disclosure, the performance of the solar cell can be significantly improved by incorporating the formamidinium iodide into the hole transport layer to form an interpenetrating interface heterojunction structure between the hole transport layer and the perovskite. The photoelectric conversion efficiency of the perovskite-silicon tandem solar cell can be enhanced by reducing the hole transport distance, increasing carrier transport efficiency, increasing open-circuit voltage and short-circuit current, and improving the fill factor.

From a comparison of Examples 1 and 7-8, it can be concluded that in the preparation process of the perovskite-silicon tandem solar cell of the preset disclosure, the concentration of the organic halide solution affects the performance of the perovskite-silicon tandem solar cell. By controlling the concentration of the organic halide solution at 1 mol/L to 1.5 mol/L, the perovskite-silicon tandem solar cell exhibits improved performance. In the case that the concentration of the organic halide solution is too high, excessive organic halide may cover the perovskite layer, hindering charge transport and reducing efficiency. In the case that the concentration of the organic halide solution is too low, the reaction with the underlying inorganic layer will be insufficient, leaving inorganic residue and reducing efficiency.

A comparison of Examples 1 and Comparative Examples 1-2 shows that two hole transport layers of different materials are provided in the perovskite solar cell of the present disclosure, where the synergistic effect between the first hole transport layer and the second hole transport layer generates multiple gain effects, which reduce charge loss and improve cell performance, thereby increasing photoelectric conversion efficiency.

The applicant declares that the above description is only specific embodiments of the present disclosure, and the protection scope of the present disclosure is not limited thereto. Those skilled in the art should understand that any changes or substitutions that can be easily conceived by those skilled in the art within the scope of the technology disclosed in the present disclosure fall within the protection and disclosure scope of the present disclosure.

## Claims

1. A perovskite-silicon tandem solar cell, comprising: a crystalline silicon solar cell substrate, an indium tin oxide (ITO) intermediate composite layer, a first hole transport layer, a second hole transport layer, a perovskite light-absorbing layer, a first electron transport layer, a second electron transport layer, a top transparent conductive layer and a conductive metal electrode, which are sequentially stacked.

2. The perovskite-silicon tandem solar cell according to claim 1, wherein the crystalline silicon solar cell substrate comprises a back conductive metal electrode, a bottom transparent conductive layer, a p-type amorphous silicon layer, a first intrinsic amorphous silicon layer, a silicon wafer, a second intrinsic amorphous silicon layer and an n-type amorphous silicon layer, which are sequentially stacked;
preferably, the n-type amorphous silicon layer is connected to the ITO intermediate composite layer.

3. The perovskite-silicon tandem solar cell according to claim 1 or 2, wherein the first hole transport layer includes a nickel oxide hole transport layer.

4. The perovskite-silicon tandem solar cell according to any one of claims 1 to 3, wherein the second hole transport layer includes a phosphoric acid carbazole (PACz)-based hole transport layer;
preferably, a material of the second hole transport layer includes any one or a combination of at least two selected from the group consisting of [2-(9-carbazol-9-yl)ethyl]phosphonic acid, [2-(dimethoxy-9-9-yl)ethyl]phosphonic acid, [2-(3,6-diphenyl-9H-carbazol-9-yl)ethyl]phosphonic acid, [4-(3,6-dimethoxy-9H-carbazol-9-yl)butyl]phosphonic acid, [4-(3,6-dimethyl-9H-carbazol-9-yl)butyl]phosphonic acid, and [4-(9H-carbazol-9-yl)butyl]phosphonic acid;
preferably, the second hole transport layer comprises formamidinium iodide.

5. The perovskite-silicon tandem solar cell according to any one of claims 1 to 4, wherein the first electron transport layer includes a fullerene C60 thin-film electron transport layer;
preferably, the second electron transport layer includes a SnO₂ thin-film electron transport layer.

6. The perovskite-silicon tandem solar cell according to any one of claims 1 to 5, wherein the top transparent conductive layer includes an ITO thin film;
preferably, the conductive metal electrode includes a silver metal electrode.

7. The perovskite-silicon tandem solar cell according to any one of claims 1 to 6, wherein the ITO intermediate composite layer has a thickness of 15 nm to 25 nm;
preferably, the first hole transport layer has a thickness of 10 nm to 20 nm;
preferably, the second hole transport layer has a thickness of 2 nm to 5 nm;
preferably, the perovskite light-absorbing layer has a thickness of 350 nm to 600 nm;
preferably, the first electron transport layer has a thickness of 15 nm to 25 nm;
preferably, the second electron transport layer has a thickness of 10 nm to 20 nm;
preferably, the top transparent conductive layer has a thickness of 100 nm to 150 nm;
preferably, the conductive metal electrode has a thickness of 800 nm to 1000 nm.

8. A method for manufacturing the perovskite-silicon tandem solar cell according to any one of claims 1 to 7, comprising steps of:
(1) depositing an ITO intermediate composite layer on an n-type microcrystalline silicon of a crystalline silicon solar cell substrate, then sputtering a first hole transport layer on the ITO intermediate composite layer, and spin-coating a second hole transport layer on the first hole transport layer;
(2) evaporating a divalent metal halide on the second hole transport layer, spin-coating an organic halide solution on the layer obtained from the evaporating, and annealing to obtain a perovskite light-absorbing layer;
(3) evaporating a first electron transport layer on the perovskite light-absorbing layer, and depositing a second electron transport layer on the first electron transport layer by atomic layer deposition; and
(4) sputtering a top transparent conductive layer on the second electron transport layer, and evaporating a conductive metal electrode on the top transparent conductive layer to obtain the perovskite-silicon tandem solar cell.

9. The method according to claim 8, wherein in step (1), a concentration of PACz-based compound in a spin-coating solution for spin-coating the second hole transport layer is 0.5 mmol/L to 1.5 mmol/L;
preferably, the spin-coating is performed at a speed of 2000 rad/s to 4000 rad/s;
preferably, the spin-coating solution comprises formamidinium iodide;
preferably, a concentration of the formamidinium iodide in the spin-coating solution is 5 mg/mL to 15 mg/mL.

10. The method according to claim 8 or 9, wherein an annealing treatment is performed after spin-coating the second hole transport layer;
preferably, the annealing treatment is performed at a temperature of 80°C to 120°C;
preferably, a duration of the annealing treatment is 8 min to 12 min.

11. The method according to any one of claims 8 to 10, wherein in step (2), the divalent metal halide includes any one or a combination of at least two selected from the group consisting of lead iodide, cesium iodide and lead bromide;
preferably, a rate of evaporating the lead iodide is 1 Å/s to 25 Å/s;
preferably, a rate of evaporating the cesium iodide is 0.04 Å/s to 1 Å/s;
preferably, a rate of evaporating the lead bromide is 0.1 Å/s to 2.5 Å/s.

12. The method according to any one of claims 8 to 11, wherein in step (2), a solute of the organic halide solution includes any one or a combination of at least two selected from the group consisting of formamidinium iodide, formamidinium bromide, methylammonium iodide, and methylammonium chloride;
preferably, a solvent of the organic halide solution includes isopropanol;
preferably, a concentration of the organic halide solution is 1 mol/L to 1.5 mol/L.

13. The method according to any one of claims 8 to 12, wherein in step (2), the annealing is performed at a temperature of 100°C to 150°C;
preferably, a duration of the annealing is 10 min to 15 min.
